# EUROPÄISCHE PATENTSCHRIFT

(11) **EP 0 907 310 B1**
(45) Veröffentlichungstag und Bekanntmachung des Hinweises auf die Patenterteilung: **18.08.2004**
(21) Anmeldenummer: 98117786.8
(22) Anmeldetag: 18.09.1998
(51) Int. Cl.: H05K 7/20, H01R 4/34, H02M 7/00, H01L 23/50

(54) **Anschlussvorrichtung für thermisch belastete Stromleiter, insbesondere in Umrichtern oder dergleichen**
Connecting device for power leads subjected to thermal stresses, particularly for rectifiers or similar
Dispositif de connexion pour conducteur de puissance soumis à des contraintes thermiques pour redresseurs et autres

(30) Priorität: 01.10.1997 DE 29717550 U
(43) Veröffentlichungstag der Anmeldung: 07.04.1999
(73) Patentinhaber: SIEMENS AKTIENGESELLSCHAFT, 80333 München (DE)
(72) Erfinder: Ackva, Ansgar, Dr., 97082 Würzburg (DE); Steinshorn, Axel, Dipl.-Ing., 97957 Wittighausen (DE)

(56) Entgegenhaltungen:
- EP-A- 0 249 646
- EP-A- 0 578 108
- WO-A-96/15577
- US-A- 4 458 305

## Beschreibung

Die Erfindung bezieht sich auf eine Anschlußvorrichtung für thermisch belastete Stromleiter, insbesondere in Umrichtern oder dergleichen, gemäß Anspruch 1; derartige Anschlußvorrichtungen sind Teil von mit elektronischen Baugruppen bestückten Geräten wie Wechselrichtern, Gleichspannungswandlern, Ladegeräten oder dergleichen und dienen zur Kontaktierung von thermisch belasteten Stromschienen, über die z.B. äußere Speiseleitungen mit Bauteilen des Gerätes verbunden sind.

Zur Reduzierung der Betriebstemperatur des Geräteinnnenraums eines derartigen Gerätes und insbesondere zum Schutz der darin enthaltenen elektronischen Baugruppen wird üblicherweise eine gesonderte Belüftung durch einen Ventilator benötigt und/oder der Einsatz von thermisch höher spezifizierten Bauteilen bzw. Stromleitern mit entsprechend vergrößertem Querschnitt und somit erhöhtem Bauvolumen vorgesehen.

Gemäß Aufgabe vorliegender Erfindung soll auf einfache Weise eine zumindest gleiche oder sogar verbesserte Kühlung bei reduzierbarem Bauvolumen erreicht werden. Die Lösung dieser Aufgabe gelingt durch eine Anschlußvorrichtung gemäß Hauptanspruch; vorteilhafte Ausgestaltungen der Erfindung sind jeweils Gegenstand der Unteransprüche.

Die erfindungsgemäße Anschlußvorrichtung erlaubt bei einfacher Fertigungs- und Montagetechnik über die Wärmeleitkörper eine schnelle und direkte Ableitung der unerwünschten Betriebswärme von den Stromleitern an den Kühlkörper; dadurch lassen sich das Bauvolumen eines solchen Gerätes sowie dessen Gewicht und dessen Kosten durch den möglichen Verzicht auf zusätzliche Ventilatoren und/oder thermisch höher spezifizierte'Bauteile wesentlich reduzieren. Das an sich vorhandene, erfindungsgemäß lediglich durch die Wärmeleitkörper zu ergänzende Klemmbrett wirkt als zusätzliche Wärmesenke.

Nach einer Ausgestaltung der Erfindung ist in noch weitergehender Vereinfachung vorgesehen, als Wärmeleitkörper zwischen dem Stromleiter einerseits und dem Kühlkörper andererseits eine Schraube, insbesondere eine Normschraube, in dem Klemmbrett zu haltern, die mit ihrem Schraubenkopf den Kühlkörper wärmekontaktiert und an deren freies Gewindeschaftende der Stromleiter zur Kontaktgabe direkt anschraubbar ist.

Die Erfindung sowie weitere vorteilhafte Ausgestaltungen der Erfindung gemäß Merkmalen der Unteransprüche werden im folgenden anhand schematisch dargestellter Ausführungsbeispiele in der Zeichnung näher erläutert; darin zeigen:
- FIG: 1 eine Anschlußvorrichtung in Seitenansicht;

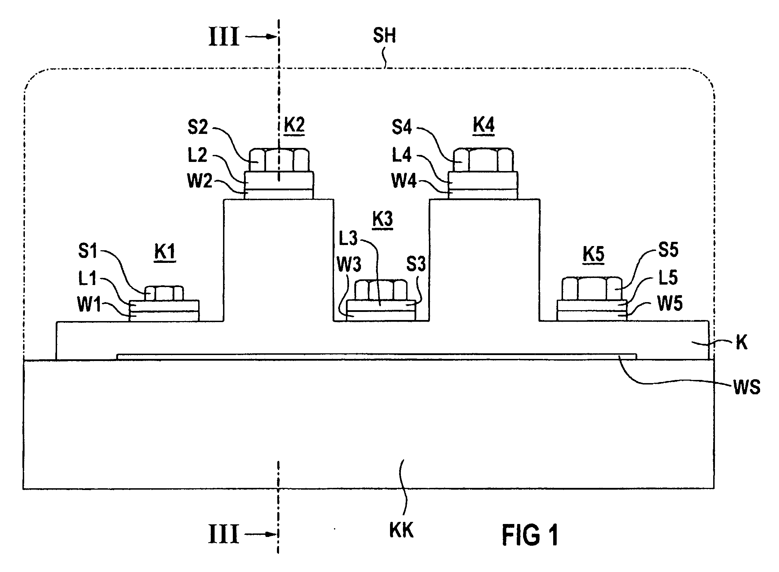

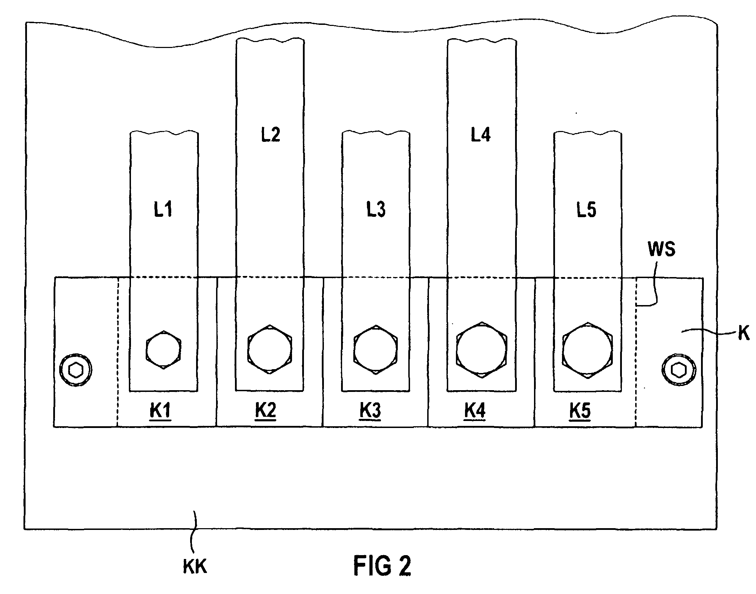

- FIG 2: eine Teil-Draufsicht auf die Anschlußvorrichtung gemäß FIG 1;
- FIG 3: die Anschlußvorrichtung gemäß FIG 1 im Schnittverlauf III-III;
- FIG 4: eine erste Alternativausführung zur Anschlußvorrichtung gemäß FIG 3;
- FIG 5: eine zweite Alternativausführung zur Anschlußvorrichtung gemäß FIG 3.

Die Figuren zeigen eine Anschlußvorrichtung mit einem auf der Oberfläche eines Kühlkörpers KK angeordneten Klemmbrett K mit fünf Kontakt-Anschlüssen K1-K5 für fünf Stromleiter L1-L5 in Form von Flach-Stromschienen; das Klemmbrett K mit den Kontakt-Anschlüssen K1-K5 für die Stromleiter L1-L5 ist innerhalb einer topfförmigen Schutzhaube SH angeordnet, die mit dem Kühlkörper KK somit einen geschlossenen Geräteinnenraum bildet, in den die Anschlußvorrichtung mit den thermisch belasteten Stromleitern L1-L5 eingeschlossen ist.

Die Kontakt-Anschlüsse K1-K5 bestehen im wesentlichen jeweils aus einer Kontaktbuchse KB1-KB2, die wie das Klemmbrett K vorzugsweise aus einem elektrisch isolierenden Thermoplast gebildet ist, und einem von dieser Kontaktbuchse KB1-KB5 jeweils aufgenommen, insbesondere eingespritzten, z.B. aus Messing bestehenden Wärmeleitkörper W1-W5. An ihrem jeweils, dem Kühlkörper KK abgewandten freien Kontaktende sind die Wärmeleitkörper W1-W5 mittels Schrauben S1-S5 mit als Stromleiter L1-L5 vorgesehen Flachstromschienen flächig kontaktiert und an ihren gegenüberliegenden Enden in mittelbare oder unmittelbare Wärmeleitverbindung mit der Oberfläche des Kühlkörpers KK gestellt.

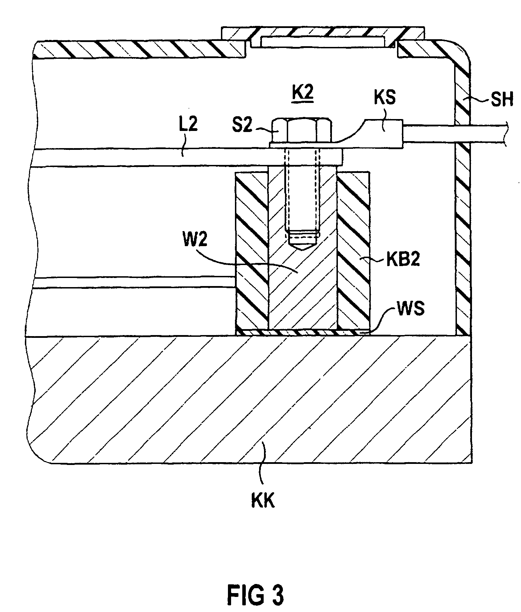

FIG 3 zeigt eine erste Ausführung eines Kontakt-Anschlusses, bei dem ein Wärmeleitkörper W2 aus Messing in eine Kontaktbuchse KB2 des Klemmbretss K eingespritzt ist; in eine Gewindebuchse des Wärmeleitkörpers W2 ist eine Schraube S2 einschraubbar und dabei ein durch einen Strom großer Stromstärke thermisch belasteter Stromleiter L2 mit einem Kabelschuh KS einer nach außen führenden Leitung, z.B. zur Ansteuerung eines Elektromotors, elektrisch und insbesondere wärmeleitend mit dem Wärmeleitkörper W2 kontaktierbar.

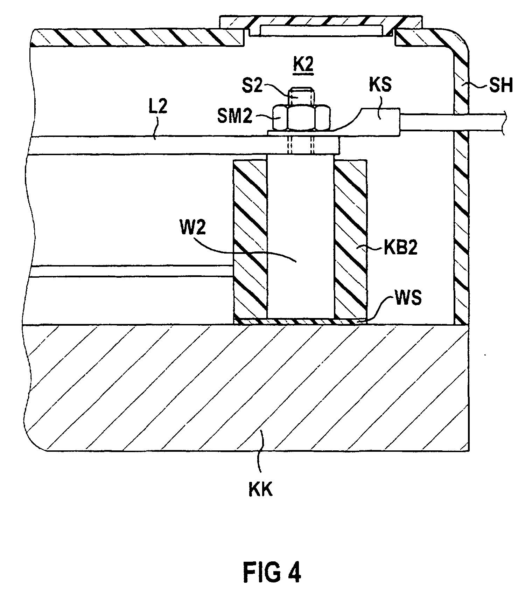

FIG 4 zeigt eine gegenüber der Ausführung nach FIG 3 weiter vereinfachte, jedoch hinsichtlich der Wärmeableitung zu dem Kühlkörper KK gleich wirksame erfindungsgemäße Ausgestaltung; dazu ist der Wärmeleitkörper W2 selbst an seinem stromleiterseitigen Ende einstückig als Schraube S2 mit einem Gewindeschaft ausgebildet, auf den eine Schraubenmutter SM2 aufschraubbar ist und dabei wiederum den Stromleiter L2 mit dem Kabelschuh KS2 elektrisch und mit dem Wärmeleitkörper W2 besonders intensiv wärmeleitend verbindet.

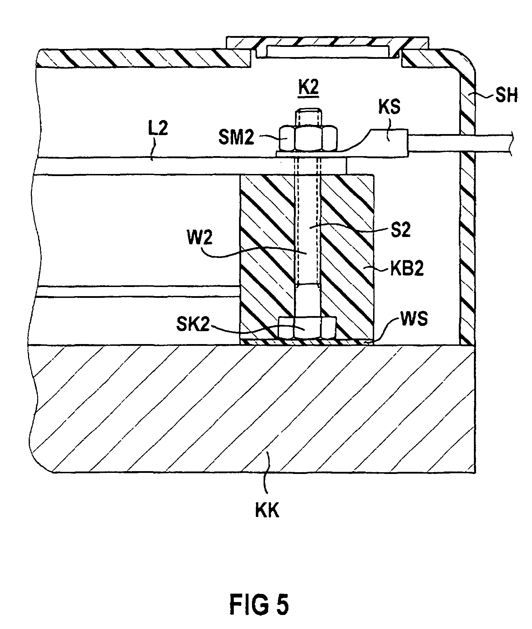

Gemäß einer weiteren, in FIG 5 dargestellten Vereinfachung ist der Wärmeleitkörper W2 mit einstückigem Gewindeschaft nach FIG 4 ersetzt durch eine in die Kontaktbuchse KB2 eingespritzte Norm-Schraube S2, derart daß einerseits deren Schraubenkopf SK2 bei einfacher formschlüssiger Umspritzsicherung im Klemmbrett K eine großflächige Wärmeleitung zu dem Kühlkörper KK gewährleisten kann und andererseits auf deren freies, aus der Kontaktbuchse KB2 herausragendes Gewindeschaftende eine Schraubenmutter SM2 zu Kontaktgabe des Stromleiters L2 mit dem Kabelschuh KS und dem Wärmeleitkörper W2 in Form der Norm-Schraube S2 selbst aufschraubbar ist.

Nach einer Ausgestaltung der Erfindung ist zur zusätzlichen Verbesserung der Wärmeableitung zwischen den Wärmeleitkörpern W1-W5 und der Oberfläche des Kühlkörpers KK eine Wärmeleit-Zwischenschicht WS derart vorgesehen, daß die Wärme der einzelnen, gegebenenfalls unterschiedlich wärmebelasteten Wärmeleitkörper W1-W5 möglichst großflächig und gleichmäßig auf die Oberfläche des Kühlkörpers KK verteilbar ist. Zweckmäßigerweise besteht diese Wärmeleit-Zwischenschicht WS aus elektrisch isolierendem Material; derartige Materialien sind an sich bekannt und bestehen beispielsweise aus elastischem, mit Aluminiumoxys gefülltem "Low Modulus Silikon-Polymer" auf einem Glasfaserträger. Aufgrund der Materialflexibilität dieser Wärmeleit-Zwischenschicht lassen sich in vorteilhafter Weise auch Oberflächenunebenheiten, insbesondere des Kühlkörpers, im Sinne einer guten Wärmeverteilung ausgleichen.

## Patentansprüche

1. Anschlußvorrichtung für thermisch belastete Stromleiter, insbesondere in Umrichtern oder dergleichen;
- mit thermisch belasteten Stromleitern (L1-L5);
- mit Kontakt-Anschlüssen (K1-K5) als Teil eines Klemmbretts (K), mit denen die Stromleiter (L1-L5) verbunden sind;
- mit einem Kühlkörper (KK), der in Verbindung mit dem Klemmbrett (K) steht;
- mit Wärmeleitkörpern (W1-W5) zwischen den Stromleitern (L1-L5) einerseits und dem Kühlkörper (KK) andererseits als integraler Bestandteil der Kontakt-Anschlüsse (K1-K5) des Klemmbretts (K).

2. Anschlußvorrichtung nach dem vorhergehenden Anspruch
- mit einem außerhalb der Wärme-Kontaktierung zu dem Kühlkörper (KK) bzw. außerhalb der Elektro-Kontaktierung zu den Stromleitern (L1-L5) von dem Klemmbrett (K) gehaltenen, insbesondere eingespritzten, Wärmeleitkörper (W1-W5).

3. Anschlußvorrichtung nach zumindest einem der vorhergehenden Ansprüche
- mit Kontakt-Anschlüssen (K1-K5) in Form von Schraub-Kontakten oder dergleichen zwischen den Stromleitern (L1-L5) und den Wärmeleitkörpern (W1-W5).

4. Anschlußvorrichtung nach dem vorhergehenden Anspruch
- mit einem an den Wärmeleitkörper (W1-W5) jeweils über eine Schraube (S1-S5) angeschraubten Stromleiter (L1-L5).

5. Anschlußvorrichtung nach zumindest einem der vorhergehenden Ansprüche 3 bzw. 4
- mit einem Wärmeleitkörper (W1-W5), der jeweils einstückig mit einem Anschraubteil oder dergleichen für die Kontaktgabe mit einem Stromleiter (L1-L5) ausgebildet ist.

6. Anschlußvorrichtung nach zumindest einem der vorhergehenden Ansprüche 3 bis 5
- mit einem Wärmeleitkörper (W2) in Form einer Schraube (S2), insbesondere einer Normschraube, mit Wärmekontaktgabe zwischen dem Schraubenkopf (SK2) und Kühlkörper (KK).

7. Anschlußvorrichtung nach zumindest einem der vorhergehenden Ansprüche
- mit Kontakt-Anschlüssen (K1-K5) in Form von Hochstrom-Kontakten für als Stromleiter (L1-L5) vorgesehene Stromschienen, insbesondere Flach-Stromschienen.

8. Anschlußvorrichtung nach zumindest einem der vorhergehenden Ansprüche
- mit einer zusätzlichen die Wärme der Wärmeleitkörper (W1-W5) über die klemmbrettseitige Kühlfläche des Kühlkörpers (KK) verteilenden Wärmeleit-Zwischenschicht (WS), insbesondere einer elektrisch isolierenden Wärmeleit-Zwischenschicht.

9. Anschlußvorrichtung nach zumindest einem der vorhergehenden Ansprüche
- mit gleichzeitig an den Kontakt-Anschlüssen (K1-K5) außer den Stromleitern (L1-L5) jeweils angeschlossenem weiterem Leitungskontakt, insbesondere Kabelschuh (KS).

10. Anschlußvorrichtung nach zumindest einem der vorhergehenden Ansprüche
- mit einem Einschluß der Stromleiter (L1-L5) bzw. der Kontakt-Anschlüsse (K1-K5) in einen Geräteinnenraum, insbesondere in einen durch den Kühlkörper (KK) und eine darauf aufgesetzte Schutz-Haube (SH) umschlossenen Geräteinnenraum.

## Claims

1. A connecting device for thermally loaded current conductors, particularly in rectifiers or similar;
- having thermally loaded current conductors (L1-L5);
- having contact terminals (K1-K5) as part of a terminal board (K) to which the current conductors (L1-L5) are connected;
- having a heatsink (KK) which is connected to the terminal board (K);
- having heat-conducting bodies (W1-W5) disposed between the current conductors (L1-L5) on the one side and the heatsink (KK) on the other side as an integral component of the contact terminals (K1-K5) of the terminal board (K).

2. The connecting device according to the preceding claim,
- having a heat-conducting body (W1-W5), in particular one which is injected, which is held by the terminal board (K) outside of the thermal contacting element to the heatsink (KK) or outside of the electrical contacting element to the current conductors (L1-L5).

3. The connecting device according to at least one of the preceding claims,
- having contact terminals (K1-K5) in the form of screw contacts or similar between the current conductors (L1-L5) and the heat-conducting bodies (W1-W5).

4. The connecting device according to the preceding claim,
- having a current conductor (L1-L5) screwed to the heat-conducting body (W1-W5) in each case by means of a screw (S1-S5).

5. The connecting device according to at least one of the preceding claims 3 or 4,
- having a heat-conducting body (W1-W5) which is in each case embodied as a single piece with a screw-on part or similar for making contact with a current conductor (L1-L5).

6. The connecting device according to at least one of the preceding claims 3 to 5,
- having a heat-conducting body (W2) in the form of a screw (S2), in particular a standard screw, with thermal contact being established between the screw head (SK2) and the heatsink (KK).

7. The connecting device according to at least one of the preceding claims,
- having contact terminals (K1-K5) in the form of high-current contacts for busbars, in particular flat busbars, provided as current conductors (L1-L5).

8. The connecting device according to at least one of the preceding claims,
- having an additional heat-conducting intermediate layer (WS) distributing the heat of the heat-conducting bodies (W1-W5) via the cooling surface of the heatsink (KK) on the terminal board side, said heat-conducting intermediate layer (WS) being in particular an electrically insulating heat-conducting intermediate layer.

9. The connecting device according to at least one of the preceding claims,
- having a further cable contact, in particular a cable shoe (KS), simultaneously connected in each case to the contact terminals (K1-K5) in addition to the current conductors (L1-L5).

10. The connecting device according to at least one of the preceding claims,
- having the current conductors (L1-L5) or the contact terminals (K1-K5) enclosed in an equipment interior space, in particular in an equipment interior space enclosed by the heatsink (KK) and a protective cover (SH) placed thereupon.

## Revendications

1. Dispositif de connexion pour des conducteurs de puissance soumis à des contraintes thermiques, en particulier dans des redresseurs ou analogues, comprenant :
- des conducteurs de puissance (L1-L5) soumis à des contraintes thermiques ;
- des raccords de contact (K1-K5) faisant partie d'une plaque à bornes (K), auxquels les conducteurs de puissance (L1-L5) sont raccordés ; .
- un corps de refroidissement (KK), qui est en relation avec la plaque à bornes (K) ;
- des corps conducteurs de la chaleur (W1-W5) entre les conducteurs de puissance (L1-L5) d'une part et le corps de refroidissement (KK) d'autre part, faisant partie intégrante des raccords de contact (K1-K5) de la plaque à bornes (K).

2. Dispositif de connexion selon la revendication précédente, comprenant :
- un corps conducteur de la chaleur (W1-W5) maintenu, en particulier par injection, par la plaque à bornes (K) à l'extérieur du contact thermique avec le corps de refroidissement (KK) respectivement à l'extérieur du contact électrique avec les conducteurs de puissance (L1-L5).

3. Dispositif de connexion selon au moins une des revendications précédentes, comprenant :
- des raccords de contact (K1-K5) sous la forme de contacts à vis ou analogues entre les conducteurs de puissance (L1-L5) et les corps conducteurs de la chaleur (W1-W5).

4. Dispositif de connexion selon la revendication précédente, comprenant :
- un conducteur de puissance (L1-L5) vissé au corps conducteur de la chaleur (W1-W5) chaque fois par une vis (S1-S5).

5. Dispositif de connexion selon au moins une des revendications précédentes 3 respectivement 4, comprenant :
- un corps conducteur de la chaleur (W1-W5), qui est chaque fois formé d'une seule pièce avec une partie à visser ou analogue pour assurer le contact avec un conducteur de puissance (L1-L5).

6. Dispositif de connexion selon au moins une des revendications précédentes 3 à 5, comprenant :
- un corps conducteur de la chaleur (W2) sous la forme d'une vis (S2), en particulier d'une vis normalisée, assurant un contact thermique entre la tête de la vis (SK2) et le corps de refroidissement (KK).

7. Dispositif de connexion selon au moins une des revendications précédentes, comprenant :
- des raccords de contact (K1-K5) sous la forme de contacts à courant fort pour des barres conductrices prévues comme conducteurs de puissance (L1-L5), en particulier des barres conductrices plates.

8. Dispositif de connexion selon au moins une des revendications précédentes, comprenant :
- une couche intermédiaire supplémentaire conductrice de la chaleur (WS), répartissant la chaleur des corps conducteurs de la chaleur (W1-W5) sur la face de refroidissement du corps de refroidissement (KK) du côté de la plaque à bornes, en particulier une couche intermédiaire conductrice de la chaleur et électriquement isolante.

9. Dispositif de connexion selon au moins une des revendications précédentes, comprenant :
- un autre contact de ligne chaque fois raccordé simultanément aux raccords de contact (K1-K5) en plus des conducteurs de puissance (L1-L5), en particulier un soulier de câble (KS).

10. Dispositif de connexion selon au moins une des revendications précédentes, comprenant :
- une insertion des conducteurs de puissance (L1-L5), respectivement des raccords de contact (K1-K5) dans un espace intérieur de l'appareil, en particulier dans un espace intérieur de l'appareil délimité par le corps de refroidissement (KK) et un capot de protection (SH) posé sur celui-ci.
